Europäisches Patentamt

European Patent Office

Office européen des brevets

(11) Publication number: **0 406 232 B1**

# EUROPEAN PATENT SPECIFICATION

(45) Date of publication of patent specification: **22.06.94** (51) Int. Cl.⁵: **F02P 7/077**, H03K 5/19

(21) Application number: **88903220.7**

(22) Date of filing: **26.03.88**

(86) International application number:
**PCT/EP88/00256**

(87) International publication number:
**WO 89/09335 (05.10.89 89/24)**

(54) **METHOD AND APPARATUS FOR MONITORING ROTATION.**

(43) Date of publication of application:
**09.01.91 Bulletin 91/02**

(45) Publication of the grant of the patent:
**22.06.94 Bulletin 94/25**

(84) Designated Contracting States:
**DE FR GB IT SE**

(56) References cited:
**EP-A- 0 020 071        WO-A-85/05511
DE-A- 2 933 516        FR-A- 2 557 699
US-A- 3 930 201        US-A- 4 305 072
US-A- 4 672 325**

**Patent Abstracts of Japan, vol. 7, no. 226
(E-202)(1371), 7 October 1983, & JP-A-58 115
923**

**IBM Technical Disclosure Bulletin, vol. 24,
no. 12, May 1982, G.R. Frazier: " Audio data
separation", pages 6327-6329**

(73) Proprietor: **ROBERT BOSCH GMBH
Postfach 30 02 20
D-70442 Stuttgart(DE)**

(72) Inventor: **VOGEL, Wolfgang
Robert-Koch-Strasse 27
D-7016 Gerlingen(DE)**

## Description

The present invention relates to the monitoring of rotation and more particularly to monitoring the rotation of a member such as a disc, the circumference of which has a series of regularly spaced normal markings and additionally at least one reference marking. Such arrangements are used to monitor the rotation of the crankshaft of a motor vehicle engine so that a signal processing unit can be used to determine the point of ignition and the point of fuel injection. Such arrangements are disclosed in DE-A-3423664, and in DE-A-2933516.

In an existing system of the type in which a plurality of equally-spaced normal grooves are provided around the circumference of a disc, the reference groove may be an additional one following shortly after one of the other grooves. The output signal of an associated inductive pick-up is sinusoidal for each groove. A pulse generator produces a square wave signal during the positive amplitude, the mark/space ratio being relatively constant. If the relationship between a high time (mark) and the preceding low time (space) is substantially higher, this means that it is a reference pulse.

In order to recognise with confidence the difference between normal pulses and reference pulses in all cases, even during acceleration and slowing down and in spite of component tolerances, the groove width and the inductive pick-up must be so seleted that no overlapping or cross-over occurs.

Arrangements for detecting a reference position even during acceleration and slowing down are known from US-A-4305072. In the known arrangement a magnetic sensor is located close to a rotating ring gear. The reference mark is a gap of greater length. Circuit means generate an output signal representing the reference position by comparing the amplitude of the charged voltage of a campacitor with a predetermined value.

Another arrangement with an additional tooth is known from the US-A-3930201. A counter counts forwardly when sensing a tooth and backwardly when sensing a gap so that the count state of the counter after a tooth-gap count will be nearly zero. The reference mark is one tooth with a gap in its middle. When the reference mark has passed, the counter reaches a negative value, which is more negative than a threshold value and a reference signal will be provided.

The WO-A-8505511 describes an arrangement for detecting a reference pulse. Therefore a first counter counts clock pulses at a first rate between succesive pulses. Between the next two pulses a second counter counts clock pulses at a second rate, less than the first rate. When the counts of the second counter exeed the counts of the first counter, the second counter counts faster clock pulses between two pulses. When the number of counts of the second counter is less than the maximum count achieved by the first counter between preceding successive pulse train pulses, then a missing pulse detection signal is produced.

The present invention seeks to provide an improved use of an arrangement for identifying reference marks.

According to the present invention there is provided an arrangement for monitoring the rotation of a member having a plurality of substantially regularly spaced marks and at least one reference mark wherein the reference mark is distinguished by being of greater or smaller length than the other marks or by being directly adjacent to a spacing of greater or smaller length than the regular spacings between the other marks, comprising sensing means for detecting the marks and producing corresponding electrical output signals of a first and of a second type corresponding respectively to the ends of a mark, two storage means the contents $U_1$, $U_2$ of which are dependent upon said electrical output signals, and comparison means to determine whether the relevant mark is a reference mark, for comparing the contents of the storage means, characterised in that the contents $U_1$ of one of the storage means are increased at a substantially constant rate between receipt of a signal of the first type and the immediately following signal of the second type and are steadily decreased between receipt of a signal of the second type and the immediately following signal of the first type, and the contents $U_2$ of the other storage means are steadily increased at a lower rate between receipt of successive signals of the same type, and that the comparison means compares the contents of the two storage means at the moment of receipt of a signal of the second type.

An advantage of such an arrangement and the use of the arrangement is that a simple comparison of the contents of the two storage means permits an unambiguous determination of whether a particular mark is a reference mark.

The storage means may operate in an analogue manner and may comprise first and second capacitors which are charged, and in one case discharged, by respective steady currents. Means may be provided for adjusting the magnitudes of the respective currents; this has the advantage of maintaining the capacitor voltage high compared to noise and other disturbances even at high speeds.

Alternatively the storage means may operate in a digital manner and may comprise first and second counters which are counted in one direction, and in one case both directions, at respective steady rates.

A preferred use of an arrangement of the present invention will now be described, by way of example only, with reference to the accompanying drawings of which:

Fig 1 shows a pulse-processing circuit of an arrangement in accordance with the present invention; and

Fig 2 shows a voltage diagram indicating the voltages at various points in the circuit of Fig 1.

In an arrangement according to the present invention a disc is attached coaxially with the camshaft of the engine of a motor vehicle. The circumference of the disc has a plurality of equally-spaced reference marks in the form of rectangular grooves. Between two of these regularly-spaced "normal grooves" there is provided an additional, "reference" groove of substantially the same size and shape as the normal grooves. This may correspond to the top dead-centre position of a first cylinder of the engine, with reference to which fuel injection and electronic ignition are conventionally timed.

An inductive pick-up 20 is located next to the disc to detect the passage of the grooves and provides an output voltage indicated at S in 2 Figure. Each groove gives rise to a substantially sinusoidal curve having both a positive and a negative half-cycle. The output from the pick-up is fed to a pulse generator 30 which produces the pulsed signal P. The pulses have relatively short "high" times and relatively long "low" times. The leading and trailing edges of the pulses are used to control the charging and discharging of first and second capacitors C1 and C2. The control of the charging and discharging is effected by a first logic circuit 40 associated with current sources and sinks 50.

Upon occurrence of a trailing pulse edge 12, charging of the first capacitor is initiated at a constant rate and charging of the second capacitor is initiated at a lower constant rate. The voltages across the first and second capacitors are respectively indicated at $U_1$ and $U_2$.

Upon occurrence of a leading pulse edge 11, discharging of the first capacitor is initiated at a constant rate, whereas uniform charging of the second capacitor continues. At the following trailing edge 12, both capacitors are substantially instantaneously completely discharged, and charging recommences at the respective constant rates.

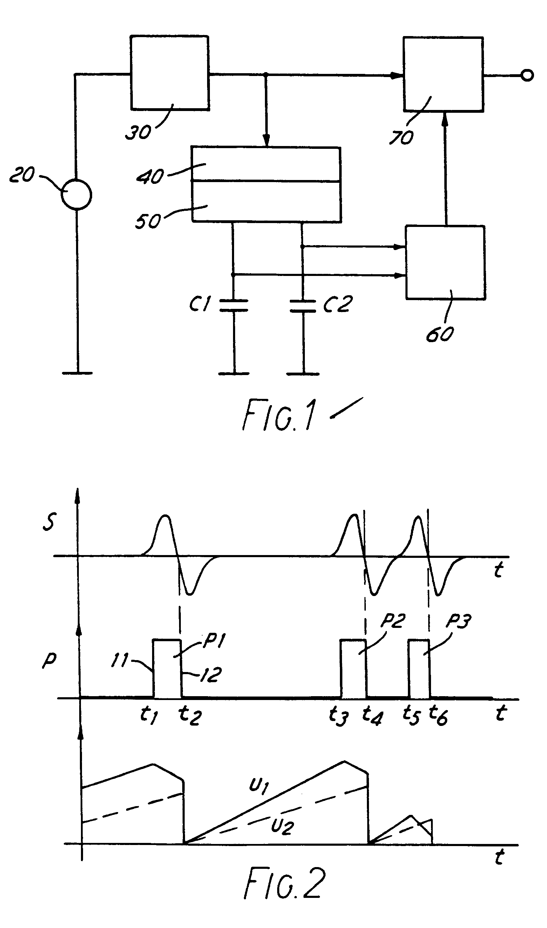

Upon the occurrence of a trailing edge 12 and before complete discharge of the capacitors is initiated, the voltages $U_1$ and $U_2$ are compared by comparison means 60. In Figure 2, pulses P1 and P2 are normal pulses and P3 is a reference pulse following shortly after pulse P2. Between the trailing edge of pulse P1 at time $t_2$ and the leading edge of pulse P2 at time $t_3$, $U_1$ has reached such a high value relative to $U_2$ that, even after partial discharge of the first capacitor, $U_1$ still exceeds $U_2$.

Thus $U_1 > U_2$ unambiguously identifies a normal pulse.

Between the trailing edge of pulse P2 at time $t_4$ and the leading edge of pulse P3 at time $t_5$, $U_1$ has not obtained a substantially higher value, so that at the time $t_6$ of the trailing edge of pulse P3, $U_1$ lies below $U_2$.

Thus $U_2 > U_1$ unambiguously identifies a reference pulse eg a top dead-centre pulse.

The output of the comparison means 60 is supplied to a second logic circuit 70 and then via output 80 to suitable signal-processing apparatus.

An advantage of the above-described arrangement is that it provides definite identification of a reference mark even with quick changes of rotational speed of the disc.

In a modification of the above arrangement, means are provided for adjusting the values of the charging and discharging currents. Thus for high disc rotation speeds, high current levels may be selected so that the capacitor voltages $U_1$ and $U_2$ are kept higher than noise and other disturbing signals.

Instead of the capacitors two counters can be employed which are triggered at different rates. The first counter counts upwards during the low part of the pulse generator output and downwards during the high part.

If at the high-low transition of the pulse generator (trailing-edge) the count of the first generator is higher than that of a second counter which only counts upwards, it represents a normal pulse. If the count of the second counter is greater than the first, it represents a reference pulse. After this comparison the counters are reset and can begin a new cycle of counting. The counting rates can be adjusted to maintain discrimination at high disc rotating speeds.

In another modification, the reference groove is separated from the preceding normal groove by an increased spacing. In this case the charging and discharging currents are selected so that the criteria for recognition of a reference pulse are reversed, i.e.

$U_2 > U_1$ normal pulse.
$U_1 > U_2$ reference pulse.

Any suitable marking may be used; for example instead of grooves, teeth , slots or holes may be provided. The reference marking may be in the form of an extra marking, a missing marking, or a marking of different size. Instead of inductively, the detector may operate in any suitable way, e.g. optically, capacitatively or ultra-sonically.

## Claims

1. Use of an arrangement for monitoring the rotation of a member having a plurality of substantially regularly spaced marks and at least one reference mark wherein the reference mark is distinguished by being of greater or smaller length than the other marks or by being directly adjacent to a spacing of greater or smaller length than the regular spacings between the other marks, comprising sensing means (20, 30) for detecting the marks and producing correspnding electrical output signals (P) of a first (12) and of a second type (11) corresponding to the ends of a mark, two storage means (C1, C2) the contents ($U_1$, $U_2$) of which are dependent upon said electrical output signals, and comparison (60) means for comparing the contents of the storage means, to determine whether the relevant mark is a reference mark, characterised in that the contents ($U_1$) of one of the storage means (C1) are increased at a substantially constant rate between receipt of a signal of the first type (12) and the immediately following signal of the second type (11) and are steadily decreased between receipt of a signal of the second type (11) and the immediately following signal of the first type (12), and the contents ($U_2$) of the other storage means (C2) are steadily increased at a lower rate between receipt of successive signals of the same type, and that the comparison means (60) compares the contents of the two storage means (C1, C2) at the moment of receipt of a signal of the first type (12).

2. Use of an arrangement according to claim 1 wherein the sensing means (20) provides output pulses, a signal of the first type being the trailing edge (12) of a pulse and a signal of the second type being the leading edge (11) of a pulse.

3. Use of an arrangement according to claim 1 or 2 wherein the storage means operate in an analogue manner.

4. Use of an arrangement according to claim 3 wherein the storage means are first (C1) and second capacitors (C2) which are charged, and in one case discharged, by respective steady currents.

5. Use of an arrangement according to claim 4 wherein means are provided for adjusting the magnitudes of the respective currents.

6. Use of an arrangement according to claim 1 or 2 wherein the storage means operate in a digital manner.

7. Use of an arrangement according to claim 6 wherein the storage means are first and second counters which are counted in one direction, and in one case both directions, at respective steady rates.

8. Use of an arrangement according to any preceding claim wherein the marks are grooves in the circumference of a conductive disc, the grooves being narrower than the spaces between them, and the sensing means comprise an inductive pick-up (20).

9. Use of an arrangement according to any preceding claim wherein the rotating member is a disc attached to the camshaft of a motor vehicle engine.

## Patentansprüche

1. Verwendung einer Vorrichtung zur Ermittlung der Drehung eines Körpers, der eine Vielzahl von in gleichmäßigem Abstand angeordneten Marken aufweist und wenigstens eine Referenzmarke, wobei die Referenzmarke sich von den anderen Marken durch größere oder kleinere Länge oder durch geringem Abstand zwischen den Winkelmarken unterscheidet mit Mitteln (20, 30) zur Erkennung der Marken und Erzeugung entsprechender elektrischer Ausgangssignale (P) eines ersten (12) und eines zweiten Typs (11), die den Enden der Markierungen entsprechen, zwei Speichermitteln (C1, C2) deren Inhalte (U1, U2) abhängig ist von den elektrischen Ausgangssignalen, Vergleichsmitteln (60) zum Vergleich des Inhalts der Speichermittel zur Bestimmung, ob die Marke eine Referenzmarke ist, dadurch gekennzeichnet, daß der Inhalt (U1) eines Speichermittels (C1) mit einer im wesentlichen konstanten Rate erhöht wird zwischen dem Empfang eines Signales des ersten Bit (12) und dem unmittelbar folgenden Signal des zweiten Typs (11) und stetig verringert wird zwischen dem Empfang eines Signales des zweiten Typs (11) und dem unmittelbar folgenden Signal des ersten Typs (12) und der Inhalt (U2) des anderen Speichermittels (C2) mit geringer Rate stetig erhöht wird zwischen dem Empfang aufeinanderfolgender Signale des gleichen Typs und die Vergleichsmittel (60) den Inhalt der beiden Speichermittel (C1, C2) vergleichen zum Zeitpunkt des Empfangs eines Signales des ersten Typs (12).

2. Verwendung einer Anordnung nach Anspruch 1, wobei die Sensormittel (20) Ausgangsimpulse erzeugen und ein Signal des ersten Typs von der Rückflanke (12) eines Pulses erzeugt wird und ein Signal des zweiten Typs von der Vorderflanke (11) eines Pulses erzeugt wird.

3. Verwendung einer Vorrichtung nach Anspruch 1 oder 2, wobei die Speichermittel in analoger Weise arbeiten.

4. Verwendung einer Anordnung nach Anspruch 3, wobei die Speichermittel ein erster (C1) und zweiter Kondensator (C2) sind, die geladen und in einem Fall entladen werden mit Hilfe von stetigen Strömen.

5. Verwendung einer Anordnung nach Anspruch 4, wobei Mittel vorgesehen sind, zur Festlegung der Höhen der verwendeten Ströme.

6. Verwendung einer Anordnung nach Anspruch 1 oder 2, wobei die Speichermittel in digitaler Art arbeiten.

7. Verwendung einer Anordnung nach Anspruch 6, wobei die Speichermittel erste und zweite Zähler sind, die in eine Richtung zählen und in einem Fall in beide Richtungen, wobei die Zählraten konstant sind.

8. Verwendung einer Anordnung nach einem der vorhergehenden Ansprüche, bei denen die Marken Vertiefungen im Umfang einer leitenden Scheibe sind, wobei die Vertiefungen näher beeinander sind als die Abstände zwischen ihnen und die Sensormittel einen induktiven Aufnehmer (20) umfassen.

9. Verwendung einer Anordnung nach einem der vorhergehenden Ansprüche, wobei der sich drehende Körper eine Scheibe ist, die auf der Nockenwelle einer Brennkraftmaschine befestigt ist.

**Revendications**

1. Utilisation d'un dispositif de contrôle de la rotation d'un élément comportant une pluralité de marques espacées essentiellement régulièrement, et au moins une marque de référence, dans lequel la marque de référence se distingue par le fait qu'elle est de plus grande longueur ou de plus petite longueur que les autres marques, ou qu'elle est directement adjacente à un espacement de plus grande longueur ou de plus petite longueur que les espacements réguliers entre les autres marques, comprenant des moyens de détection (20, 30) pour détecter les marques et produire des signaux de sortie électriques correspondants (P) d'un premier type (12) et d'un second type (11) correspondant respectivement aux extrémités d'une marque, deux moyens de stockage (C1, C2) dont les contenus ($U_1$, $U_2$) dépendent des signaux de sortie électriques, et des moyens de comparaison (60) pour comparer les contenus des moyens de stockage de manière à déterminer si la marque en question est une marque de référence, caractérisee en ce que les contenus ($U_1$) de l'un des moyens de stockage (C1) sont augmentés à un rythme essentiellement constant entre la réception d'un signal du premier type (12) et le signal immédiatement suivant du second type (11), et sont diminués de façon constante entre la réception d'un signal du second type (11) et le signal immédiatement suivant du premier type (12), en ce que les contenus ($U_2$) des autres moyens de stockage (C2) sont augmentés de façon constante à un rythme inférieur entre la réception de signaux successifs du même type, et en ce que les moyens de comparaison (60) comparent les contenus des deux moyens de stockage (C1, C2) au moment de la réception d'un signal du premier type (12).

2. Utilisation d'un dispositif selon la revendication 1, caractérisée en ce que les moyens de détection (20) fournissent des impulsions de sortie, un signal du premier type étant constitué par le bord arrière (12) d'une impulsion, et un signal du second type étant constitué par le bord avant (11) d'une impulsion.

3. Utilisation d'un dispositif selon l'une des revendications 1 ou 2, caractérisée en ce que les moyens de stockage fonctionnent de manière analogique.

4. Utilisation d'un dispositif selon la revendication 3, caractérisée en ce que les moyens de stockage sont constitués par un premier condensateur (C1) et un second condensateur (C2) qui sont chargés, et dans un cas déchargés, par des courants respectifs constants.

5. Utilisation d'un dispositif selon la revendication 4, caractérisée en ce qu'on utilise des moyens pour régler les amplitudes des courants respectifs.

6. Utilisation d'un dispositif selon l'une des revendications 1 ou 2, caractérisée en ce que les moyens de stockage fonctionnent de manière numérique.

7.  Utilisation d'un dispositif selon la revendication 6, caractérisée en ce que les moyens de stockage sont constitués par un premier compteur et un second compteur qu'on fait compter dans un direction, et dans un cas dans les deux directions, à des rythmes respectifs constants.

8.  Utilisation d'un dispositif selon l'une quelconque des revendications précédentes, caractérisée en ce que les marques sont des rainures formées dans la circonférence d'un disque conducteur, les rainures étant plus étroites que les espacements entre elles, et en ce que les moyens de détection comprennent un capteur inductif (20).

9.  Utilisation d'un dispositif selon l'une quelconque des revendications précédentes, caractérisée en ce que l'élément rotatif est un disque fixé sur le vilebrequin d'un moteur d'automobile.

FIG.1

FIG.2

7